(19) Europäisches Patentamt
European Patent Office
Office européen des brevets

(11) **EP 3 133 405 A1**

(12) **EUROPÄISCHE PATENTANMELDUNG**

(43) Veröffentlichungstag:
**22.02.2017 Patentblatt 2017/08**

(51) Int Cl.:
***G01R 1/20*** *(2006.01)*     *G01R 19/00* *(2006.01)*

(21) Anmeldenummer: **15181600.6**

(22) Anmeldetag: **19.08.2015**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA**

(71) Anmelder: **Siemens Aktiengesellschaft
80333 München (DE)**

(72) Erfinder:
- **Stelzig, Berthold
  90408 Nürnberg (DE)**
- **Pfeifer, Markus
  90455 Nürnberg (DE)**

(54) **VORRICHTUNG UND VERFAHREN ZUR MESSUNG EINER STROMSTÄRKE IN EINEM ELEKTRISCHEN LEITER**

(57)     Die Erfindung betrifft eine Vorrichtung und ein Verfahren zur Messung einer Stromstärke ($I_{IN}$) in einem elektrischen Leiter (L), wobei eine Messeinrichtung (S) zur Messung der Stromstärke vorgesehen wird. Dabei wird der elektrische Leiter (L) in eine Anzahl Teil-Leiter aufgeteilt, wobei die Teil-Leiter an ihren jeweiligen Enden elektrisch miteinander verbunden und in einem Bereich zwischen den jeweiligen Enden elektrisch voneinander isoliert werden, wobei die Messeinrichtung (S) zur Messung einer Teil-Stromstärke ($I_2$) in einem ersten der Teil-Leiter als Nebenstrompfad verwendet wird und die verbleibenden Teil-Leiter einen Hauptstrompfad bilden, und wobei eine Skaliereinrichtung die Ermittlung der Stromstärke ($I_{IN}$) aus einem Messwert der Teil-Stromstärke ($I_2$) und anhand eines Teilungsverhältnis zwischen Nebenstrompfad und dem Hauptstrompfad oder dem gesamten Leiter (L) vornimmt. Durch die Beschränkung der messtechnischen Erfassung auf einen Teil-Strom kann eine kleinere, leichtere Messeinrichtung (Stromsensor) verwendet werden.

FIG 1

EP 3 133 405 A1

**Beschreibung**

Die Erfindung betrifft eine Vorrichtung zur Messung einer Stromstärke in einem elektrischen Leiter gemäß dem Oberbegriff des Patentanspruchs 1, und ein Verfahren zur Messung einer Stromstärke in einem elektrischen Leiter gemäß dem Oberbegriff des Patentanspruchs 9.

Bei der Messung von Gleich- und/oder Wechselströmen in Umrichtern (Leistungselektronik) oder bei Antrieben werden in der Regel Stromsensoren (Messvorrichtungen zur Messung der Stromstärke) mit Ringkernen oder Shunts verwendet.

Bei zunehmender Höhe des zu messenden Stroms ergibt sich dabei zum Einen das Problem, dass bei Stromsensoren mit Ringkern durch die größer werdenden Magnetfelder das Kernvolumen zunehmen muss, um Sättigungseffekte zu verhindern. Dadurch wächst das Bauvolumen der Stromsensoren an. Bei Kompensationsstromwandlern mit einer Sekundärwicklung auf dem Ringkern nimmt zudem häufig aufgrund nötig werdender höherer Windungszahl und größeren Drahtquerschnitts auch noch das Volumen der Sekundärwicklung zu, wodurch das Bauvolumen weiter wächst. Insgesamt führt bei Stromsensoren mit Ringkern also eine Erhöhung des zu messenden Stroms zu einer Zunahme des Bauvolumens und der Masse.

Bei der Strommessung mit Shunts (Messwiderstand) muss zur Erreichung einer bestimmten Messgenauigkeit beim Maximalstrom eine entsprechende Mindestspannung abfallen (bestimmt durch den Rauschpegel der im System verwendeten Komponenten). Eine Erhöhung des zu messenden Stroms führt deshalb aufgrund des minimal zur Erreichung einer bestimmten Messgenauigkeit nötigen Spannungsabfalls am Shunt automatisch zu einer größeren Verlustleistung im Shunt und deshalb in der Regel zu einer größeren Bauform und Masse des Shunts, um die höhere Verlustleistung abführen zu können.

Allgemein sinkt mit steigender Baugröße bzw. steigendem Messbereich oft die nutzbare Bandbreite der Strom-Messeinrichtungen, so dass insbesondere in der Energieversorgung und Leistungselektronik transiente Vorgänge nicht präzise erfasst werden können.

Bisher wird die Zunahme des Bauvolumens und der Masse von Shunts bzw. Stromsensoren bei der Messung höherer Ströme akzeptiert und äußert sich in einem höheren Bauvolumen bzw. Masse des Geräts, in dem die Strommessung integriert ist.

Es ist eine Aufgabe der vorliegenden Erfindung, eine Vorrichtung zur Messung der Stromstärke in einem elektrischen Leiter vorzuschlagen, die präzise ist und eine kompakte Bauform aufweist.

Es ist eine Kernidee der erfindungsgemäßen Lösung dieser Aufgabe, einen stromführenden Leiter, insbesondere eine Stromschiene oder einen Streifenleiter einer Leiterplatte, in Teil-Leiter aufzuteilen, und nur den Strom in einem der Teil-Leiter, vorzugsweise dem mit dem geringeren Querschnitt, zu messen, und aus diesem Messergebnis den Gesamtstrom zu berechnen. Da anstelle des Gesamtstroms nur ein Teilstrom gemessen werden muss, können kleinere, leichtere Stromsensoren verwendet werden.

Die Lösung der Aufgabe sieht insbesondere eine Vorrichtung gemäß Patentanspruch 1 und ein Verfahren gemäß Patentanspruch 9 vor.

Dabei wird eine Vorrichtung zur Messung einer Stromstärke in einem elektrischen Leiter vorgeschlagen, wobei eine Messeinrichtung zur Messung der Stromstärke vorgesehen ist. Dabei ist der elektrische Leiter in eine Anzahl Teil-Leiter aufgeteilt, wobei die Teil-Leiter an ihren jeweiligen Enden miteinander elektrisch verbunden und in einem Bereich zwischen den jeweiligen Enden elektrisch voneinander isoliert sind, wobei die Messeinrichtung zur Messung einer Teil-Stromstärke in einem ersten der Teil-Leiter als Nebenstrompfad angeordnet ist und die verbleibenden Teil-Leiter einen Hauptstrompfad bilden, und wobei eine Skaliereinrichtung zur Ermittlung der Stromstärke aus einem Messwert der Teil-Stromstärke und anhand eines Teilungsverhältnis zwischen Nebenstrompfad und dem Hauptstrompfad oder dem gesamten Leiter vorgesehen ist. Durch die Beschränkung der messtechnischen Erfassung auf einen Teil-Strom kann eine kleinere, leichtere Messeinrichtung (Stromsensor) verwendet werden.

Außerdem wird zur Lösung der Aufgabe ein Verfahren zur Messung einer Stromstärke in einem elektrischen Leiter vorgeschlagen, wobei eine Messeinrichtung zur Messung der Stromstärke vorgesehen wird. Dabei ist vorgesehen, dass der elektrische Leiter in eine Anzahl Teil-Leiter aufgeteilt wird, wobei die Teil-Leiter an ihren jeweiligen Enden miteinander elektrisch verbunden und in einem Bereich zwischen den jeweiligen Enden elektrisch voneinander isoliert werden, wobei die Messeinrichtung zur Messung einer Teil-Stromstärke in einem ersten der Teil-Leiter als Nebenstrompfad verwendet wird und die verbleibenden Teil-Leiter einen Hauptstrompfad bilden, und wobei eine Skaliereinrichtung die Ermittlung der Stromstärke aus einem Messwert der Teil-Stromstärke und anhand eines Teilungsverhältnis zwischen Nebenstrompfad und dem Hauptstrompfad oder dem gesamten Leiter vornimmt. Mit diesem Verfahren können die bereits anhand der Vorrichtung diskutierten Vorteile realisiert werden.

Vorteilhafte Ausgestaltungen der Erfindung sind in den abhängigen Patentansprüchen angegeben. Die für die Vorrichtung angegebenen vorteilhaften Ausgestaltungen gelten sinngemäß auch für das erfindungsgemäße Verfahren, und umgekehrt. Die in den abhängigen Patentansprüchen diskutierten vorteilhaften Ausgestaltungen können sowohl einzeln, als auch in beliebiger Kombination miteinander realisiert werden.

Vorteilhaft ist der elektrische Leiter streifenförmig, wobei durch eine schlitzförmige Unterbrechung in Längsrichtung eine Teilung in Hauptstrompfad und Nebenstrompfad gegeben ist. Dadurch ist die Erfindung gut auf Stromschienen in der elektrischen Energieversorgung und auf Leiterbahnen von Leiterplatten anwendbar. Die Unterteilung des Leiters in Teil-Leiter lässt sich bei diesen Anwendungen auch gut nachträglich gestalten, beispielsweise durch Einfräsen von Unterbrechungen.

Die Erfindung ist auch vorteilhaft einsetzbar, wenn der elektrische Leiter mehradrig ist, wobei durch Herausführung oder Spleißung einer Anzahl Adern eine Teilung in Hauptstrompfad und Nebenstrompfad möglich ist.

Eine universell einsetzbare Lösung, insbesondere zur Nachrüstung bestehender Anlagen, ist gegeben, indem der elektrische Leiter aus einem Hauptleiter und einem zusätzlich vorgesehenen und parallel angeordnetem Messleiter besteht, wobei der Hauptleiter den Hauptstrompfad und der Messleiter den Nebenstrompfad bildet.

Vorteilhaft ist das durch die Skaliereinrichtung verwendete Teilungsverhältnis anhand des Verhältnisses der Impedanz des Nebenstrompfades zu der Impedanz des Hauptstrompfades bestimmt, so dass Messwerte der Impedanzen genutzt werden können, was insbesondere bei unregelmäßigen Geometrien zweckmäßig ist. Alternativ kann insbesondere bei streifenförmigen Leitern, bei denen ein linearer Zusammenhang zwischen der Breite eines Strompfades und dem längenbezogenen Widerstand bzw. Impedanz besteht, vorteilhaft das durch die Skaliereinrichtung verwendete Teilungsverhältnis anhand des Verhältnisses des gesamten Leiterquerschnitts des Leiters zu dem Leiterquerschnitt des Nebenstrompfades bestimmt werden. Die Skaliereinrichtung kann vorteilhaft durch eine in Software ausgestaltete Umrechnung der Messwerte realisiert sein.

Ausführungsbeispiele der erfindungsgemäßen Lösung werden nachfolgend anhand der Zeichnungen erläutert.

Dabei zeigen:

Figur 1  eine erste Ausführungsform mit einer in Längsrichtung geschlitzten Leiterbahn oder Stromschiene,

Figur 2  eine zweite Ausführungsform mit einem Kabel zur Realisierung des Nebenstrompfades, und

Figur 3  ein elektrisches Ersatzschaltbild der Messvorrichtungen aus Figur 1 und Figur 2.

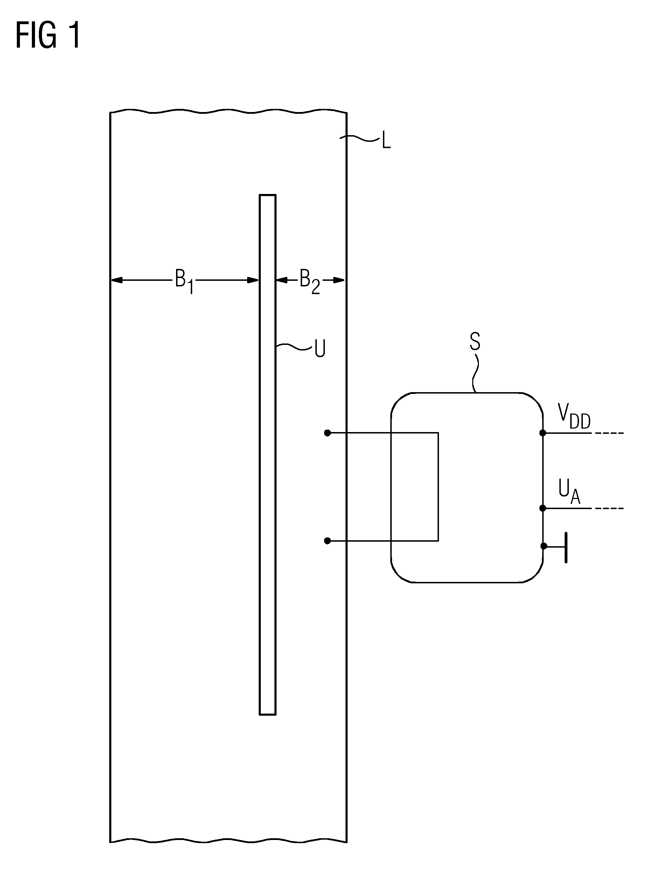

In der Figur 1 ist ein Leiter L dargestellt, beispielsweise eine Stromschiene zur elektrischen Versorgung eines elektrischen Verbrauchers. Der Leiter L ist mit einer schlitzförmigen Unterbrechung U versehen, die zum einen den Leiter L in einen Hauptstrompfad mit der Breite $B_1$ und einen Nebenstrompfad mit der Breite $B_2$ unterteilt. Zudem unterbricht die Unterbrechung U den Nebenstrompfad, so dass der Strom des Nebenstrompfades durch den Sensor S geleitet wird. Der Sensor S ist dabei eine Strommesseinrichtung gemäß dem Stand der Technik, beispielsweise ein induktiver Stromwandler, ein Kompensationsstromwandler oder ein Shunt. Der Sensor S verfügt ggf. über eine Spannungsversorgung $V_{DD}$ und hat einen Ausgang $U_A$ mit dem Meßsignal.

Bei der abgebildeten Vorrichtung wird der zu messende Strom im Leiter L gemäß dem Breitenverhältnis $B_1$ zu $B_2$ im Verhältnis 1:n geteilt, wobei nur der um den Faktor n geteilte Strom im Nebenstrompfad gemessen wird. Der Gesamtstrom errechnet sich aus dem Messergebnis als das (n+1)-fache des gemessenen Teilstroms; zur Berechnung kann eine einfache Skalierungseinrichtung (nicht dargestellt) verwendet werden. Dadurch kann ein Sensor S (Stromsensor) verwendet werden, der statt des Gesamtstroms nur den n-ten Teil des Gesamtstroms messen kann, d.h. die Anordnung erweitert den Messbereich eines Stromsensors um den Faktor n.

Zur Stromteilung wird parallel zum Hauptstrompfad einen Nebenstrompfad (Parallelpfad) mit höherem Widerstand bzw. größerer Impedanz realisiert, der über den Sensor S (Stromsensor) geschlossen ist. Dieser Strom im Parallelpfad wird also mit Hilfe des Sensors S gemessen. Das Teilungsverhältnis der Ströme von Haupt- und Parallelstrompfad ergibt sich aus dem Verhältnis des ohmschen Widerstands von Haupt- und Parallelstrompfad. Bei streifenförmigen Leitern mit über die Breite konstanter Dicke entspricht das Teilungsverhältnis dem Verhältnis der Breiten $B_1$ zu $B_2$.

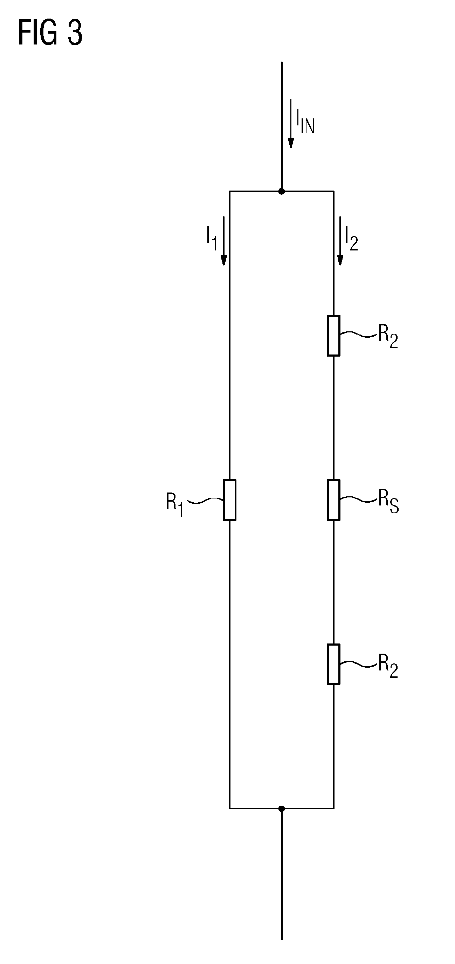

In der Figur 3 ist ein Ersatzschaltbild dazu angegeben.

Die Realisierung gemäß Figur 1 beruht auf einem Schlitz als Unterbrechung U in einer Stromschiene oder Leiterbahn. Die Widerstände der Teil-Leiter zu beiden Seiten des Schlitzes, also des Haupt- und des Nebenstrompfades, ergeben sich aus der Geometrie und der Leitfähigkeit des Materials zu $R_1$ und zweimal $R_2$ (ober- und unterhalb des Sensors in der Figur 1). Mit dem Widerstand $R_s$ des Sensors S ergibt sich für das Verhältnis der Ströme links und rechts des Schlitzes

$$I_1/I_2 = (2R_2 + R_S)/R_1 = n \quad .$$

Wird der Teilstrom $I_2$ mit dem Sensor S gemessen, ergibt sich der zu messende Gesamtstrom $I_{IN}$ daraus gemäß

$$I_{IN} = I_1 + I_2 = I_2(1 + I_1/I_2) = I_2(1+n)$$

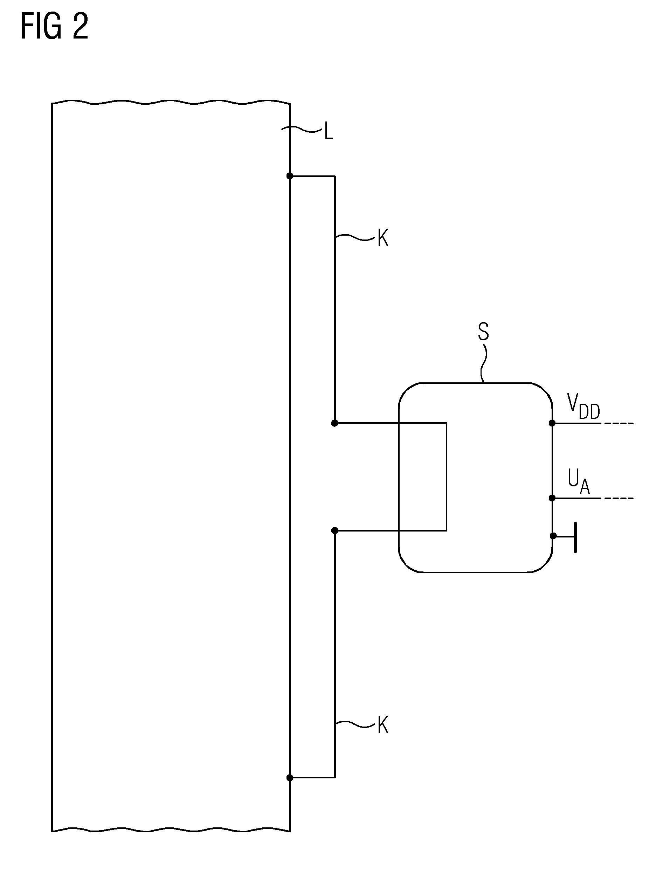

In der Figur 2 ist dargestellt, dass anstelle eines Schlitzes in einer Stromschiene oder Leiterbahn alternativ ein Parallelpfad auch mit Hilfe eines Kabels K realisiert werden kann. Diese Variante kann auch bei bestehenden Systemen ohne Notwendigkeit des Auftrennens bestehender Verschienungen nachgerüstet werden. Das Ersatzschaltbild aus Figur 3 gilt sinngemäß auch für diese Variante.

Eine Ausgestaltung dieser Ausführungsform kann für Leiterplatten (PCB - physical layer board) genutzt werden, wobei Haupt- und Teilstrom (Hauptstrompfad und Nebenstrompfad) in Leiterbahnen auf verschiedenen Lagen (Layern) aufgeteilt werden, wobei die Leiterbahnen des Hauptstrompfades und des Nebenstrompfades vorzugsweise übereinander überlappend angeordnet sind. Die Leiterbahnen sind an den Enden über Durchkontaktierungen, sog. "Vias", leitend miteinander verbunden. Die Leiterbahn für den Teilstrom, also der Nebenstrompfad, ist am Ort des Sensors S unterbrochen, der Strompfad für diesen Teilstrom wird über den Sensor S geschlossen. Für die Leiterbahnen für Haupt- und Teilstrom können unterschiedliche Kupferstärken, also eine unterschiedliche Dicke der leitfähigen Schicht, und/oder auch eine unterschiedliche Breite der Leiterbahnen verwendet werden. Bei einer Dickkupferleiterplatte kann z.B. der Hauptstrom auf einer Lage mit Dickkupfer geführt werden, und der Teilstrom auf einer Lage mit geringerer Kupferschichtdicke. Der Hauptstrom kann auch auf mehrere Leiterbahnen in unterschiedlichen Lagen aufgeteilt werden, um größere Gesamtströme zu erreichen.

Es ist in einer weiteren Ausgestaltung auch eine Kombination von Stromschienen, wie anhand der Figur 1 diskutiert, und Leiterplatten möglich, wobei dann über die Leiterplatte im wesentlichen der Nebenstrompfad realisiert wird; die Leiterplatte wird also anstelle des anhand der Figur 2 diskutierten Kabels K eingesetzt. Der Hauptstrom fließt in der Stromschiene, auf diese ist eine Leiterplatte so geschraubt, daß nur die Leiterbahn für den Teilstrom (Nebenstrompfad) leitend mit der Schiene verbunden ist. Die Enden des Nebenstrompfades können dazu mittels leitfähiger Schraubverbindungen mit der Stromschiene, also dem Hauptstrompfad, verbunden sein. Die Leiterbahn für den Teilstrom (Nebenstrompfad) ist am Ort des Sensors S unterbrochen, der Strompfad für den Teilstrom wird also über den Sensor S geschlossen.

Der vorgeschlagene Ansatz hat viele Vorteile gegenüber der bestehenden Lösung. Da anstelle des Gesamtstroms nur ein Teilstrom gemessen werden muss, können kleinere, leichtere Stromsensoren verwendet werden. Diese Stromsensoren sind zudem preiswerter, weisen eine geringere Verlustleistung auf und haben in der Regel eine höhere Bandbreite, d.h., es können hiermit schnellere transiente Vorgänge beobachtet werden. Zudem kann durch eine Ersparnis im Bauvolumen, der Masse und der Verlustleistung bei den Stromsensoren erzielt werden, was direkt zu einer Reduzierung der Masse, des Volumens und der Verlustleistung der Geräte führen, in denen die Stromsensoren eingesetzt werden. Dadurch ergeben sich Kostenvorteile und Wettbewerbsvorteile.

Mit dem vorgeschlagenen Ansatz wird zudem der Messbereich eines Sensors um den Faktor n erhöht, somit können Stromsensoren mit Primärstromanschluß für die Leiterplattenmontage (hier sind Anschlüsse am Sensor für den zu messenden Strom vorhanden, der durch den Sensor fließt) auch zur Messung von solchen Strömen verwendet werden, in denen ansonsten Durchsteckwandler (Stromwandler mit Ringkern ohne Anschlüsse für den Primärstrom - der Primärstrom muss dabei über eine Schiene/Kabel durch den Ringkern hindurch geführt werden) verwendet werden müssen. Stromsensoren mit Primärstromanschluß sind häufig einfacher konstruktiv zu handhaben; deren Einsatzgebiet wird durch die Anwendung der Erfindung deutlich erweitert.

## Patentansprüche

1. Vorrichtung zur Messung einer Stromstärke ($I_{IN}$) in einem elektrischen Leiter (L),
   wobei eine Messeinrichtung (S) zur Messung der Stromstärke vorgesehen ist,
   **dadurch gekennzeichnet,**
   **dass** der elektrische Leiter (L) in eine Anzahl Teil-Leiter aufgeteilt ist, wobei die Teil-Leiter an ihren jeweiligen Enden elektrisch miteinander verbunden und in einem Bereich zwischen den jeweiligen Enden elektrisch voneinander isoliert sind,
   **dass** die Messeinrichtung (S) zur Messung einer Teil-Stromstärke ($I_2$) in einem ersten der Teil-Leiter als Nebenstrompfad angeordnet ist und die verbleibenden Teil-Leiter einen Hauptstrompfad bilden, und
   **dass** eine Skaliereinrichtung zur Ermittlung der Stromstärke ($I_{IN}$) aus einem Messwert der Teil-Stromstärke ($I_2$) und anhand eines Teilungsverhältnis zwischen Nebenstrompfad und dem Hauptstrompfad oder dem gesamten Leiter (L) vorgesehen ist.

2. Vorrichtung gemäß Patentanspruch 1,
   **dadurch gekennzeichnet,**
   **dass** der elektrische Leiter (L) streifenförmig ist, wobei durch eine schlitzförmige Unterbrechung in Längsrichtung eine Teilung in Hauptstrompfad und Nebenstrompfad gegeben ist.

3. Vorrichtung gemäß Patentanspruch 2,
   **dadurch gekennzeichnet,**
   **dass** der elektrische Leiter (L) eine Stromschiene einer elektrischen Energieversorgung ist.

4. Vorrichtung gemäß Patentanspruch 2,
   **dadurch gekennzeichnet,**
   **dass** der elektrische Leiter (L) eine Leiterbahn einer Leiterplatte ist.

5. Vorrichtung gemäß Patentanspruch 1,

**dadurch gekennzeichnet,**
**dass** der elektrische Leiter (L) mehradrig ist, wobei durch Herausführung oder Spleißung einer Anzahl Adern eine Teilung in Hauptstrompfad und Nebenstrompfad gegeben ist.

6. Vorrichtung gemäß Patentanspruch 1,
   **dadurch gekennzeichnet,**
   **dass** der elektrische Leiter (L) aus einem Hauptleiter und einem zusätzlich vorgesehenen und parallel angeordnetem Messleiter besteht, wobei der Hauptleiter den Hauptstrompfad und der Messleiter den Nebenstrompfad bildet.

7. Vorrichtung gemäß einem der vorhergehenden Patentansprüche,
   **dadurch gekennzeichnet,**
   **dass** das durch die Skaliereinrichtung verwendete Teilungsverhältnis anhand des Verhältnisses der Impedanz des Nebenstrompfades zu der Impedanz des Hauptstrompfades bestimmt ist.

8. Vorrichtung gemäß einem der Patentansprüche 1 bis 6,
   **dadurch gekennzeichnet,**
   **dass** das durch die Skaliereinrichtung verwendete Teilungsverhältnis anhand des Verhältnisses des gesamten Leiterquerschnitts des Leiters (L) zu dem Leiterquerschnitt des Nebenstrompfades bestimmt ist.

9. Verfahren zur Messung einer Stromstärke ($I_{IN}$) in einem elektrischen Leiter (L),
   wobei eine Messeinrichtung (S) zur Messung der Stromstärke vorgesehen wird,
   **dadurch gekennzeichnet,**
   **dass** der elektrische Leiter (L) in eine Anzahl Teil-Leiter aufgeteilt wird, wobei die Teil-Leiter an ihren jeweiligen Enden elektrisch miteinander verbunden und in einem Bereich zwischen den jeweiligen Enden elektrisch voneinander isoliert werden,
   **dass** die Messeinrichtung (S) zur Messung einer Teil-Stromstärke ($I_2$) in einem ersten der Teil-Leiter als Nebenstrompfad verwendet wird und die verbleibenden Teil-Leiter einen Hauptstrompfad bilden, und
   **dass** eine Skaliereinrichtung die Ermittlung der Stromstärke ($I_{IN}$) aus einem Messwert der Teil-Stromstärke ($I_2$) und anhand eines Teilungsverhältnis zwischen Nebenstrompfad und dem Haupstrompfad oder dem gesamten Leiter (L) vornimmt.

# FIG 1

$B_1$

$B_2$

L

U

S

$V_{DD}$

$U_A$

FIG 2

FIG 3

$I_{IN}$

$I_1$

$I_2$

$R_2$

$R_1$

$R_S$

$R_2$

Europäisches
Patentamt

European
Patent Office

Office européen
des brevets

**EUROPÄISCHER RECHERCHENBERICHT**

Nummer der Anmeldung

EP 15 18 1600

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 6 456 061 B1 (CRINITI JOSEPH [US] ET AL) 24. September 2002 (2002-09-24) * Spalte 1, Zeile 29 - Zeile 35; Abbildungen 1-3 * * Spalte 2, Zeile 11 - Spalte 3, Zeile 55 * ----- | 1,2,6-9 | INV. G01R1/20 ADD. G01R19/00 |
| X | FR 3 006 056 A1 (CONTINENTAL AUTOMOTIVE FRANCE [FR]; CONTINENTAL AUTOMOTIVE GMBH [DE]) 28. November 2014 (2014-11-28) * Seite 4, Zeile 25 - Seite 6, letzter Zeile; Abbildungen 1,2 * * Seite 8, Zeile 25 - Zeile 26 * ----- | 1-4,8,9 | |
| X | EP 1 028 321 A2 (HEILMANN MICHAEL [DE]; WALLJAN MARTIN [DE]) 16. August 2000 (2000-08-16) * Absatz [0003] - Absätze [0008], [0011], [0018], [0019]; Abbildungen 1,8 * ----- | 1,5,6,8, 9 | |
| X | WO 02/33424 A2 (VACUUMSCHMELZE GMBH & CO KG [DE]; PREUSSE NORBERT [DE]) 25. April 2002 (2002-04-25) * Seite 3, Zeile 4 - Zeile 15; Abbildungen 1-4 * * Seite 3, Zeile 36 - Seite 6, Zeile 21 * * Seite 6, Zeile 33 - Seite 9, Zeile 28 * ----- | 1,4,6,7, 9 | RECHERCHIERTE SACHGEBIETE (IPC) G01R |
| X | DE 10 2011 078334 A1 (BOSCH GMBH ROBERT [DE]) 3. Januar 2013 (2013-01-03) * Absätze [0006], [0007], [0008], [0013], [0031] - Absatz [0038]; Abbildungen 2a,2b,3a,3b * ----- -/-- | 1-3,6,9 | |

Der vorliegende Recherchenbericht wurde für alle Patentansprüche erstellt

| Recherchenort | Abschlußdatum der Recherche | Prüfer |
|---|---|---|
| München | 9. Februar 2016 | Hof, Klaus-Dieter |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
..........
& : Mitglied der gleichen Patentfamilie, übereinstimmendes Dokument

EPO FORM 1503 03.82 (P04C03)

**Europäisches Patentamt**
**European Patent Office**
**Office européen des brevets**

# EUROPÄISCHER RECHERCHENBERICHT

Nummer der Anmeldung

EP 15 18 1600

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2015/088438 A1 (KINSELLA JAMES J [US]) 26. März 2015 (2015-03-26) * Absätze [0001], [0003], [0004], [0009] - Absätze [0011], [0014], [0016]; Ansprüche 1,2,6,8 * ----- | 1,6,7,9 | |
| X | US 6 528 960 B1 (RODEN GAREY GEORGE [US] ET AL) 4. März 2003 (2003-03-04) * Zusammenfassung; Abbildungen 2a,2b * ----- | 1,5,9 | |
| X | FR 2 868 844 A1 (VALEO ELECTRONIQUE SYS LIAISON [FR]) 14. Oktober 2005 (2005-10-14) * Seite 2, Zeile 30 - Seite 3, Zeile 14; Abbildung 2 * * Seite 4, Zeile 3 - Zeile 31 * ----- | 1,2,7-9 | |
| X | DE 10 2012 102034 A1 (PHOENIX CONTACT GMBH & CO [DE]) 12. September 2013 (2013-09-12) * Absätze [0015], [0017], [0032] - Absatz [0044]; Abbildungen 1-3 * ----- | 1,7-9 | RECHERCHIERTE SACHGEBIETE (IPC) |
| X | US 4 182 982 A (LOCKE PHILIP F JR [US] ET AL) 8. Januar 1980 (1980-01-08) * Spalte 6, Zeile 12 - Spalte 9, Zeile 50; Abbildungen 2,4 * ----- | 1,9 | |

Der vorliegende Recherchenbericht wurde für alle Patentansprüche erstellt

| Recherchenort | Abschlußdatum der Recherche | Prüfer |
|---|---|---|
| München | 9. Februar 2016 | Hof, Klaus-Dieter |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 15 18 1600

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-02-2016

| Im Recherchenbericht angeführtes Patentdokument | Datum der Veröffentlichung | Mitglied(er) der Patentfamilie | Datum der Veröffentlichung |
|---|---|---|---|
| US 6456061 B1 | 24-09-2002 | KEINE | |
| FR 3006056 A1 | 28-11-2014 | KEINE | |
| EP 1028321 A2 | 16-08-2000 | DE 19905118 A1<br>EP 1028321 A2 | 31-08-2000<br>16-08-2000 |
| WO 0233424 A2 | 25-04-2002 | DE 10051138 A1<br>EP 1328818 A2<br>WO 0233424 A2 | 02-05-2002<br>23-07-2003<br>25-04-2002 |
| DE 102011078334 A1 | 03-01-2013 | DE 102011078334 A1<br>EP 2726885 A1<br>JP 5813220 B2<br>JP 2014520269 A<br>KR 20140034863 A<br>US 2014184199 A1<br>WO 2013000621 A1 | 03-01-2013<br>07-05-2014<br>17-11-2015<br>21-08-2014<br>20-03-2014<br>03-07-2014<br>03-01-2013 |
| US 2015088438 A1 | 26-03-2015 | US 2015088438 A1<br>WO 2015048095 A1 | 26-03-2015<br>02-04-2015 |
| US 6528960 B1 | 04-03-2003 | KEINE | |
| FR 2868844 A1 | 14-10-2005 | KEINE | |
| DE 102012102034 A1 | 12-09-2013 | KEINE | |
| US 4182982 A | 08-01-1980 | JP S5512497 A<br>US 4182982 A | 29-01-1980<br>08-01-1980 |

EPO FORM P0461

Für nähere Einzelheiten zu diesem Anhang : siehe Amtsblatt des Europäischen Patentamts, Nr.12/82